## Europäisches Patentamt
## European Patent Office
## Office européen des brevets

(11) Veröffentlichungsnummer: **0 028 823**
**A1**

# (12) EUROPÄISCHE PATENTANMELDUNG

(21) Anmeldenummer: 80106878.4

(22) Anmeldetag: 07.11.80

(51) Int. Cl.³: **H 01 L 23/48**
**H 01 L 21/603**

(30) Priorität: 12.11.79 DE 2945670

(43) Veröffentlichungstag der Anmeldung:
20.05.81 Patentblatt 81/20

(84) Benannte Vertragsstaaten:
BE FR GB

(71) Anmelder: SIEMENS AKTIENGESELLSCHAFT Berlin
und München
Postfach 22 02 61
D-8000 München 22(DE)

(72) Erfinder: Jung, Albert
Birkenstrasse 49
D-8028 Taufkirchen(DE)

(54) Elektrisch leitende Verbindung der aktiven Teile eines elektrischen Bauelements oder einer integrierten Schaltung mit Anschlusspunkten.

(57) Die Erfindung betrifft eine elektrisch leitende Verbindung der aktiven Teile eines elektrischen Bauelementes oder einer integrierten Schaltung mit Anschlußpunkten für den äußeren Anschluß, die aus einem sehr dünnen Golddraht (3) und einer Metallschicht (1) besteht, die sich auf dem elektrischen Bauelement (5) oder der integrierten Schaltung befindet, und der Golddraht (3) mittels Thermokompression mit der Metallschicht (1) verbunden ist, wobei zur Verbesserung des Kontaktes die Metallschicht (1) wenigstens im Bereich des durch Thermokompression gebildeten Nagelkopfes (2) des Golddrahtes (3) mit Perforationslöchern (4) versehen ist.

FIG 1

SIEMENS AKTIENGESELLSCHAFT    Unser Zeichen ·
Berlin und München            VPA 79 P 1 1 8 6 EUR

Elektrisch leitende Verbindung der aktiven Teile eines
elektrischen Bauelements oder einer integrierten Schaltung mit Anschlußpunkten

Die Erfindung betrifft eine elektrisch leitende Verbindung der aktiven Teile eines elektrischen Bauelements,
insbesondere eines Oberflächenwellenfilters, oder einer
integrierten Schaltung mit Anschlußpunkten für den äußeren Anschluß, die aus einem sehr dünnen Golddraht und
einer Metallschicht besteht, die sich auf dem elektrischen Bauelement oder der integrierten Schaltung befindet, wobei der Golddraht mittels Thermokompression mit
der Metallschicht verbunden ist.

Die aktiven Teile eines elektrischen Bauelementes, insbesondere eines Oberflächenwellenfilters oder einer integrierten Schaltung (meist auch als "Chip" bezeichnet),

Bck 1 Zi / 8.11.1979

werden mit den Anschlußpunkten der Außenanschlüsse oder mit dem Gehäuse neuerdings durch sehr feine Golddrähte (Durchmesser z.B. 25 µm) mittels Thermokompression elektrisch verbunden. Diese Technik stellt eine allgemein bekannte und angewandte Technologie dar. Die für die Thermokompression wichtigen Parameter sind Temperatur, Anpreßdruck und Zeitdauer des Vorgangs. Die Temperatur, auf die Chip und Anschlußpunkte dabei erwärmt werden, liegt in der Regel bei etwa 350...400° C. Neben metallurgischen Gründen ist eine hohe Temperatur auch für einen entsprechend hohen Reibungskoeffizienten zwischen den beiden zu verbindenden Metallen notwendig, nämlich der als Kontaktfleck ausgebildeten Metallschicht auf den Chip oder dem Bauelement bzw. einem anderen Kontaktfleck, und dem mit der Metallschicht zu verbindenden Golddraht. Die hohe Reibung tritt dabei beim Anpressen des zu einem winzigen Tropfen geschmolzenen Drahtendes auf den jeweiligen Kontaktfleck auf, wobei ein "Nagelkopf" gebildet wird.

Bei der Thermokompression handelt es sich somit im gewissen Sinne um eine Schweißung, die problematisch wird, wenn sie bei Montagetechniken angewandt werden soll, bei denen ein Gehäuse aus Kunststoff, z.B. aus thermoplastischem Kunststoff verwendet und/oder das Bauelement bzw. der Chip mittels Klebestoff befestigt wird.

Eine solche Befestigung kommt insbesondere bei Oberflächenwellenfiltern vor, die ein Substrat aus piezoelektrischem Material, beispielsweise einkristallines, piezoelektrisches Lithium-Niobat, in Form einer sehr dünnen Scheibe aufweisen, und auf diesem Substrat zur Erzeugung der Oberflächenwelle einen Eingangswandler aus

0028823

aus einer aufgefächerten Metallfläche, Metallstreifen auf dem die Laufzeit bedingenden Oberflächenbereich und mindestens einen dem Eingangswandler entsprechend ausgebildeten Ausgangswandler enthalten. Oberflächenwellenfilter dieser Art sind beispielsweise in der Zeitschrift "Proceedings of the IEEE" April 1971, Seiten 713/714 beschrieben. Die einzelnen Finger der Eingangs- und Ausgangswandler sind über entsprechende Leitungen zu als Metallschichten ausgebildeten Kontaktflecken zusammengeführt. Diese Kontaktflecken müssen mit den Anschlußstellen äußerer Stromzuführungen verbunden werden, was mittels Thermokompression, wie oben beschrieben, erfolgt.

Die Anwendung der Thermokompression zum Verbinden mindestens zweier auf einem Halbleiterkristall eines Halbleiterbauelementes in engem Abstand nebeneinander angeordneter kleinflächiger Elektroden mit Anschlußdrähten durch Kaltschweißen oder Thermokompression ist in der DE-AS 12 57 976 beispielsweise beschrieben. Auch bei solchen Halbleiterbauelementen oder auch bei integrierten Schaltungen unter Anwendung von Halbleitermaterial sind Kontaktflecke vorhanden, die durch einen feinen Draht miteinander elektrisch zu verbinden sind; dies geschieht durch die oben beschriebene Thermokompression.

Wegen der Temperaturempfindlichkeit des Gehäusematerials und/oder des Klebers ist eine Erwärmung auf die normal hohe Thermokompressionstemperatur nicht möglich.

Bisher wurde hierfür der Weg eingeschlagen, daß die für die Thermokompression erforderliche Wärme über die beheizte Kontaktierkapillare und den Golddraht bzw. die
Goldkugel an die Kontaktierstelle transportiert wurde.
Durch mechanisch bzw. elektromechanisch angeregte Transversalschwingungen der Kontaktierkapillare wird die zur
Schweißung notwendige Reibung erzeugt.

Der vorliegenden Erfindung liegt die Aufgabe zugrunde,
insbesondere bei niedrigeren Chip-Temperaturen (höchstens 200$^{\circ}$ C) die Reibung zwischen den beiden miteinander zu verschweißenden Materialien, nämlich Golddraht
und Kontaktierfleck, zu erhöhen und auf diese Weise
einen verbesserten Kontaktiervorgang zu ermöglichen.

Zur Lösung dieser Aufgabe ist die elektrisch leitende
Verbindung der eingangs angegebenen Art erfindungsgemäß dadurch gekennzeichnet, daß die Metallschicht wenigstens im Bereich des durch Thermokompression gebildeten Nagelkopfes des Golddrahtes mit Perforationslöchern versehen ist.

Durch die Erfindung wird somit die Aufgabe in der Weise
gelöst, daß zwischen den zu verschweißenden Teilen eine
zusätzliche Reibung durch eine besondere geometrische
Ausbildung des Kontaktflecks auf dem Trägerkörper erzielt wird.

Dazu wird der bisher übliche ganzflächige Kontaktfleck
durch eine Vielzahl von insbesondere rechteckigen Löchern perforiert. Durch diese strukturierte Metallisierung wird bei der Thermokompression die Deformation
der am Golddraht hängenden Goldkugel und damit der plastische Materialfluß vergrößert. Der durch Oxydation,
insbesondere bei Aluminium als Material für die Kontaktfläche, und/oder durch organische bzw. anorganische Verunreinigungen der Oberfläche der Metallisierung verminderte Reibungskoeffizient und die damit beeinträchtigte Benetzbarkeit der Kkntaktoberfläche wird durch die Perforation entscheidend verbessert. Die Anzahl von Mikroschweißstellen, die sich unter dem infolge der Thermokompression entstehenden Nagelkopf ausbilden, nimmt beträchtlich zu und damit auch die Qualität des Kontaktes.

Die Ausbildung des mit Löchern versehenen Kontaktflecks läßt sich bei der Fotolithographie zur Herstellung der Metallschicht ohne Mehraufwand verwirklichen. Lediglich bei der Anfertigung der Fotomaske ist die Perforation einmalig zu berücksichtigen.

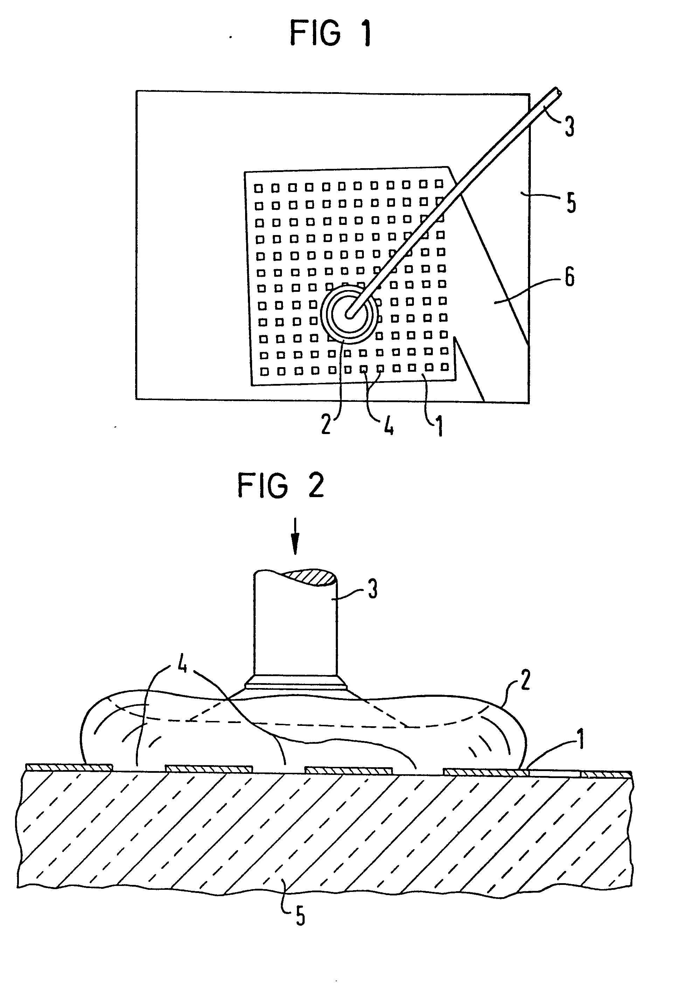

In den beigefügten Figuren 1 und 2 ist mit 5 der Trägerkörper bezeichnet, der ein elektrisches Bauelement, ein Teil eines solchen Bauelementes, ein Halbleiterkörper bei Halbleiterbauelementen oder bei integrierten Schaltungen sein kann. Der Kontaktfleck 1 weist mehrere Perforationslöcher 4 auf, u.zw. zumindest an demjenigen Oberflächenbereich des Trägerkörpers 5, der sich unterhalb des Nagelkopfes 2 des Golddrahtes 3 befindet. Als Stromzuführung ist die Leiterbahn 6 vorhanden, die den Kontaktfleck 1 mit dem aktiven Teil des Bauelementes verbindet.

1 Patentanspruch
2 Figuren

<u>Patentanspruch</u>

Elektrisch leitende Verbindung der aktiven Teile eines elektrischen Bauelements, insbesondere eines Oberflächenwellenfilters, oder einer integrierten Schaltung mit Anschlußpunkten für den äußeren Anschluß, die aus einem sehr dünnen Golddraht und einer Metallschicht besteht, die sich auf dem elektrischen Bauelement oder der integrierten Schaltung befindet, wobei der Golddraht mittels Thermokompression mit der Metallschicht verbunden ist, d a d u r c h   g e k e n n z e i c h - n e t , daß die Metallschicht (1) wenigstens im Bereich des durch Thermokompression gebildeten Nagelkopfes (2) des Golddrahtes (3) mit Perforationslöchern (4) versehen ist.

FIG 1

FIG 2

0028823

## Europäisches Patentamt

# EUROPÄISCHER RECHERCHENBERICHT

Nummer der Anmeldung

EP 80 10 6878

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | <u>FR - A - 2 358 749</u> (I.T.T.)<br>* Figur 3; Ansprüche 1,4 *<br>& DE - A - 2 631 810<br><br>-- | Einziger |
| | <u>GB - A - 1 231 042</u> (FERRANTI)<br>* Seite 2, Zeilen 59-65 *<br><br>---- | Einziger |

### KLASSIFIKATION DER ANMELDUNG (Int Cl ³)

H 01 L 23/48
         21/603

### RECHERCHIERTE SACHGEBIETE (Int Cl ³)

H 01 L 23/48
         21/603

### KATEGORIE DER GENANNTEN DOKUMENTE

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 10-02-1981 | DE RAEVE |

EPA form 1503.1   06.78